Europäisches Patentamt

European Patent Office

Office européen des brevets

(19)

(11) Numéro de publication: **0 340 099**
**A1**

# DEMANDE DE BREVET EUROPEEN

(21) Numéro de dépôt: 89401172.5

(22) Date de dépôt: 25.04.89

(51) Int. Cl.⁴: **G 06 K 19/06**

(30) Priorité: 28.04.88 FR 8805671
16.09.88 FR 8812088

(43) Date de publication de la demande:
02.11.89 Bulletin 89/44

(84) Etats contractants désignés:
BE CH DE ES FR GB IT LI NL SE

(71) Demandeur: SCHLUMBERGER INDUSTRIES
50, avenue Jean Jaurès
F-92120 Montrouge (FR)

(72) Inventeur: Mollet, Jean Paul
47, Elysée 2
F-78170 La Celle Saint Cloud (FR)

Rose, René
15, rue de l'Etang
F-78190 Voisin le Bretonneux (FR)

(74) Mandataire: Dronne, Guy
SCHLUMBERGER INDUSTRIES 50, avenue Jean Jaurès
F-92120 Montrouge (FR)

(54) Procédé de réalisation de cartes comportant des éléments graphiques et cartes obtenues par ledit procédé.

(57) Pour réaliser les éléments graphiques requis sur les faces du corps de carte on met en place dans un moule (42, 44) un élément support (10) portant le module électronique (20) et muni de graphismes (22, 24) sur ses faces (10a, 10b). On injecte dans le moule (42, 44) un matériau plastique transparent.

EP 0 340 099 A1

**Description**

# PROCEDE DE REALISATION DE CARTES COMPORTANT DES ELEMENTS GRAPHIQUES ET CARTES OBTENUES PAR LEDIT PROCEDE

La présente invention a pour objet des cartes, notamment des cartes à mémoire électronique dont le corps de carte comporte des éléments graphiques tels que des informations alphanumériques ou des dessins par exemple à but décoratif ou publicitaire.

Lorsque l'élément graphique présente une certaine complexité soit par la forme du tracé soit par la nature des nuances de couleur à obtenir l'étape d'impression du graphisme, par sérigraphie, par offset ou autres procédés, peut conduire à un échec surtout si l'on se montre très exigeant sur la qualité du graphisme et des couleurs. En cas d'échec, il faut se résoudre à mettre au rebut les cartes dont la qualité du graphisme est jugée insuffisante. Cela signifie que les coûts en matière, en composants et en usinage des étapes de fabrication de la carte précédant l'étape de réalisation du graphisme sont perdus. Ces coûts sont particulièrement élevés si la réalisation du graphisme intervient lorsqu'un module électronique a déjà été implanté dans le corps de la carte. Cette situation se présente notamment, mais non exclusivement, lorsque la carte est fabriquée en moulant le corps de la carte directement sur le module électronique selon la technique décrite dans la demande de brevet français nr 87/00446.

Selon cette technique on met en place un module électronique dans un moule dont l'empreinte définit la forme extérieure à donner au coprs de carte. Après démoulage on obtient une carte à mémoire présentant un corps de carte ayant sa forme définitive et dans lequel le module électronique est déjà implanté. Si, lors de l'étape ultérieure de réalisation du graphisme, le résultat est inacceptable, on comprend que c'est la totalité du coût de réalisation de la carte qui est perdu.

On a également proposé de réaliser le corps de la carte par moulage par injection d'un matériau plastique. Cette technique est décrite dans la demande de brevet 267 826. Pour diminuer le coût de réalisation on utilise de préférence comme matériau d'injection un acrylo-butadière styrène (ABS). Ce matériau présente l'inconvénient de mal se prêter à la réalisation de graphismes sur les faces du corps de carte par les techniques habituelles d'impression : sérigraphie ou offset.

Pour remédier à ces inconvénients un objet de l'invention est de fournir un procédé de réalisation de carte, notamment de carte à mémoire, dans lequel l'étape de réalisation du graphisme sur le corps de carte ne peut en elle-même entrainer le rejet de la carte ou qui permette de réaliser le graphisme indépendamment de la nature du matériau utilisé pour réaliser le corps de la carte.

Pour atteindre ce but, le procédé de réalisation d'une carte comportant un corps de carte présentant deux faces principales et au moins un élément graphique se caractérise en ce qu'il comprend les étapes suivantes :

a) on fournit un moule dont l'empreinte définit la forme extérieure du corps de carte,

b) On dispose dans le moule au moins un élément support comportant un élément graphique, on maintient en place ledit élément support pour qu'il reste sensiblement parallèle aux faces de l'empreinte du moule définissant les faces principales du corps de carte,

On injecte dans ledit moule un matériau plastique de telle manière que le matériau plastique occupe la totalité de l'espage limité par l'empreinte dudit moule non occupé par ledit élément support et

On démoule la pièce ainsi réalisée.

Selon un premier mode de mise en oeuvre l'élément graphique de l'élément support comprend des éléments d'impression et, lors de l'injection du matériau plastique dans le moule lesdits éléments d'impression adhérent à la face du volume du matériau plastique injecte en contact avec ledit élément support, et lors du démoulage on sépare l'élément support de la pièce moulée, par quoi lesdits éléments d'impression restent sur ladite face dudit corps.

De préférence durant l'étape b on dispose de plus dans ledit moule un module électronique présentant une face d'accès et on maintient ledit module électronique pour que sa face d'accès soit plaquée contre une des faces principales de l'empreinte, et durant l'étape c le matériau plastique remplit la totalité de l'espace limité par l'empreinte dudit moule non occupé par ledit élément support et ledit module électronique.

Selon une variante du premier mode de réalisation l'élément graphique dudit élément support comprend un premier et un deuxième élément d'impression disposés de part et d'autre d'une couche séparatrice opaque et le matériau plastique d'injection est transparent. Ainsi, visuellement, tout se passe comme si une impression était réalisée sur chacune des deux faces principales du corps de carte.

Selon un deuxième mode de mise en oeuvre ledit élément support est réalisé en un matériau non transparent muni sur au moins une de ses faces d'un élément graphique et en ce que ledit matériau plastique d'injection est transparent.

D'autres caractéristiques et avantages de l'invention apparaitront plus clairement à la lecture de la description qui suit de plusieurs modes de réalisation de l'invention donnés à titre d'exemples non limitatifs. La description se réfère au dessin annexé sur lequel :

La figure 1 est une vue en coupe verticale d'un élément support muni d'éléments graphiques selon un premier mode de mise en oeuvre de l'invention ;

La figure 2a est une vue en coupe verticale d'un moule pour la réalisation d'un corps de carte à mémoire utilisant un élément support selon la figure 1 ;

La figure 2b est une vue semblable à celle de la figure 2a montrant l'intérieur du moule après l'injection du matériau plastique.

La figure 3 montre en coupe verticale une variante de moule utilisable dans une variante du premier mode de mise en oeuvre de l'invention ;

La figure 4 montre une variante d'élément support utilisable avec le moule de la figure 3 ;

La figure 5 montre en coupe verticale partielle un corps de carte obtenu par la mise en oeuvre du procédé selon les figures 3 et 4.

La figure 6 montre en coupe verticale un moule pour la mise en oeuvre d'une deuxième variante du premier mode de réalisation de l'invention.

Les figures 7a et 7b montrent respectivement en coupe verticale et en vue de dessus un moule pour la mise en oeuvre d'un deuxième mode de réalisation de l'invention.

La figure 8 montre en coupe verticale un moule pour la mise en oeuvre d'une variante du deuxième mode de réalisation de l'invention.

La figure 9 montre en coupe verticale un élément support muni de modules électroniques ;

La figure 10 montre, en coupe verticale, un moule pour utiliser l'élément support de la figure 9 selon un troisième mode de mise en oeuvre de l'invention ;

La figure 11 montre, en vue de dessus, une carte à mémoire électronique obtenue selon le troisième mode de mise en oeuvre de l'invention ;

La figure 12, montre, en coupe verticale, plusieurs éléments support pour la réalisation d'une carte selon une variante du troisième mode de mise en oeuvre de l'invention ; et

La figure 13 montre, en coupe verticale, un moule utilisable dans la variante du troisième mode de mise en oeuvre de l'invention.

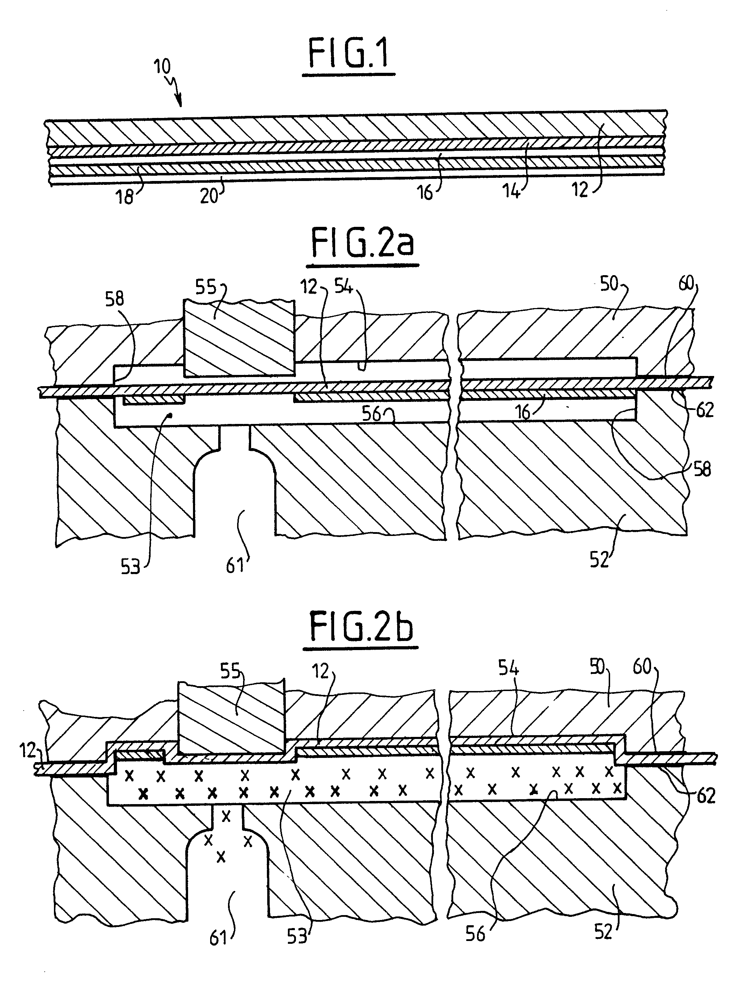

Avant d'expliquer plus en détails l'ensemble de l'invention on va décrire, en se référant à la figure 1, un élément support d'impression utilisable.

L'élément support, portant la référence 10 comporte un support 12, ou feuille support, en matériau plastique. Le support 12 est de préférence en polyester et a une épaisseur de l'ordre de 25 micromètres.

Sur ce support 12 qui joue le rôle de support mécanique sont réalisés les éléments d'impression servant ultérieurement à obtenir le graphisme souhaité. Pour chaque élément d'impression on trouve une couche de détachement 14 ; une couche de décoration 16 constituée par des pigments ; éventuellement une couche de vernis 18 ; et une couche d'adhésif 20 dont l'épaisseur est de l'ordre de 1 à 2 micromètres.

Sur une même feuille support 12 on peut réaliser un grand nombre de motifs identiques. Un tel produit est proposé notamment par la Société allemande Léonard Kurz Gmbh.

Dans l'étape suivante on réalise le corps de la carte par moulage par injection d'un matériau plastique qui est de préférence de l'ABS. Les figures 2a et 2b montrent le moule utilisé. Il comprend une partie fixe 50 et une partie mobile 52. Ces deux parties définissent une empreinte 53 qui donne la forme externe du corps de carte. La partie fixe 50 définit par sa paroi interne 54 une des faces principales du corps de carte. Dans la paroi 54 est disposé un noyau 55 qui fait saillie dans l'empreinte 53. Le noyau 55 sert à définir dans le corps de carte une cavité dans laquelle sera ultérieurement fixé le module électronique. La partie mobile 52 définit par sa paroi interne 56 la deuxième face principale du corps de carte et par sa paroi interne 58 la plus grande partie de la tranche du corps de carte. Les parties fixe 50 et mobile 52 comportent chacune une portée 60 et 62, ces deux portées étant normalement en contact mutuel lorsque le moule est fermé. Enfin la partie mobile 52 comporte une buse d'injection 61 débouchant dans la face 56 et disposée en regard du noyau 55.

Le moule étant ouvert, la bande formée par le support 12 est placée entre la partie fixe 50 et la partie mobile 52 du moule. La bande est placée par rapport à l'empreinte 53 de telle manière que le graphisme 16 portée par le support 12, soit parfaitement positionnés par rapport à la paroi latérale 58 de l'empreinte, c'est-à-dire par rapport à la tranche du corps de carte qui va être réalisé. De plus les éléments graphiques 16 sont tournés vers la face 56 de l'empreinte 53. Puis le moule est fermé. Le support 12 est pincé entre les portées 58 et 60 des deux parties du moule dans la zone du support 12 qui entoure un motif. Puis on procède à l'injection du matériau plastique dans l'empreinte 53 par la buse d'injection 61. L'ABS est injecté de préférence à une température comprise entre 220°C et 280°C.. Le matériau plastique remplit l'empreinte 53 en plaquant le support 12 contre la paroi interne 54 du moule et le noyau 55 comme le montre la figure 2b. . Le matériau plastique remplit totalement l'empreinte 53 et il est au contact du graphisme 16. Sous l'effet de la pression et de la température, les éléments décoratifs 16 se fixent sur la face correspondante du volume de matériau plastique 62 en tendant à se séparer du support 12. Ce résultat est obtenu par l'activation de la couche d'adhésif 20 et de la couche de décollement 14.

Après avoir ouvert le moule on démoule le corps de carte qui comporte le graphisme 16 désiré sur sa face principale et le corps de carte ainsi obtenu se sépare du support 12.

Il va de soi que le corps de carte devant avoir une épaisseur de 0,8 mm, l'épaisseur de l'empreinte du moule (distance entre les faces 54 et 56) doit être légèrement supérieure à cette valeur pour tenir compte de l'épaisseur de la feuille support 12.

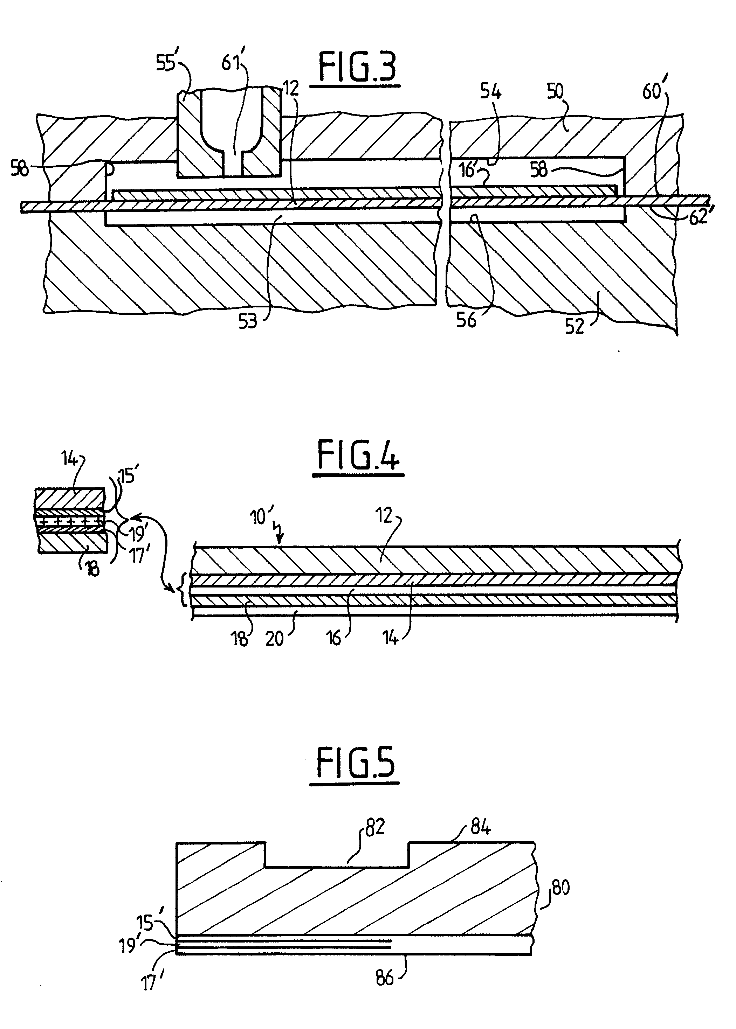

La figure 3 montre un moule pour un deuxième mode de mise en oeuvre de l'invention. Le moule comprend, comme celui des figures 2, une partie fixe 50 et une partie mobile 52. Ces deux parties définissent une empreinte interne 53 qui a sensiblement la forme que l'on veut donner au corps de carte. La partie fixe 50 définit la face principale 54 et la face latérale 58 de l'empreinte 53. Un noyau 55' fait saillie dans la face principale 54 pour définir la forme de la cavité à réaliser dans le corps de carte. Une buse d'injection 61′ est disposée dans le noyau 55′. La partie mobile 52 définit la deuxième face principale 56 de l'empreinte 53. Les parties 50 et 52 présentent deux portées de contact 60′ et 62′ qui sont en contact lorsque le moule est fermé. La portée 62′ est sensiblement dans le plan de la face principale 56.

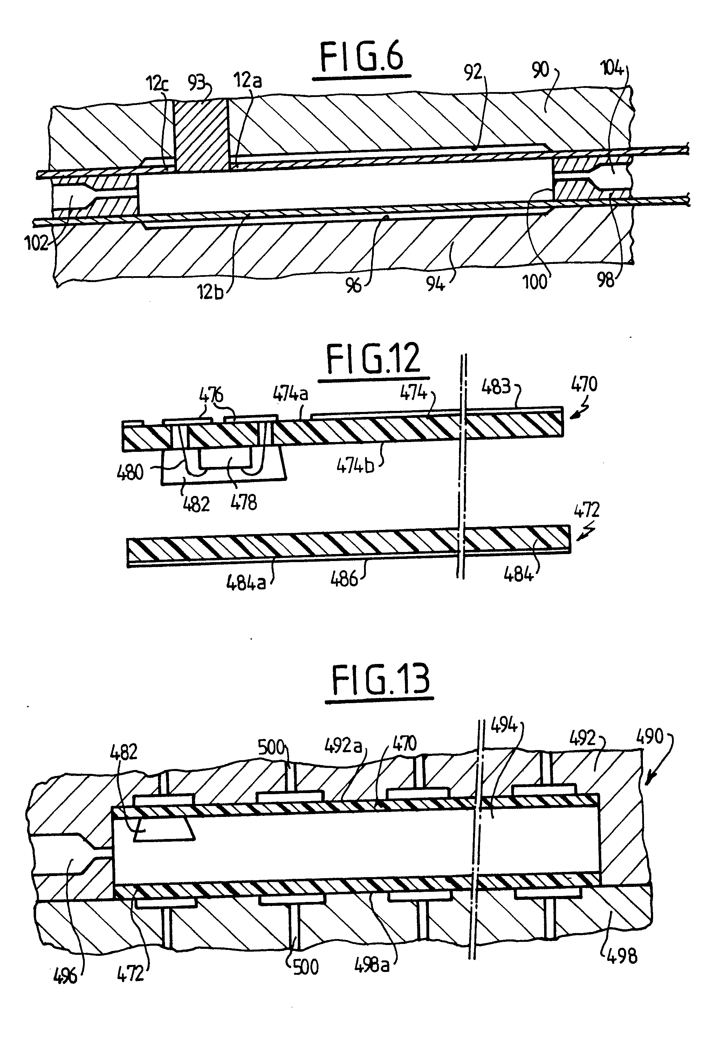

Pour la mise en oeuvre de l'invention selon la figure 3, on utilise un élément support 10′ représenté sur la figure 4. Il est identique à l'élément support 10 de la figure 1 à l'exception de la couche décorative. La couche décorative 16′ est constituée par deux sous couche décoratives 15′ et 17′ entre lesquelles est interposée une couche opaque 19′ de séparation. Ainsi la couche décorative 16′ comporte deux graphismes différents qui sont disposés de part et d'autre d'une couche opaque de séparation.

La mise en oeuvre du deuxième mode de réalisation de l'invention est la suivante : L'élément support 10′ est placé dans le moule de la figure 3 entre les parties fixes 50 et mobile 52. Puis le moule est refermé et la périphérie de la feuille support 12 entamant l'élément décoratif 16′. l'élément décoratif 16′ est tourné vers la face principale 54 de l'empreinte 53. Par la buse 61′, on injecte un matériau plastique transparent ou translucide. Il s'agit par exemple d'un polycarbonate ou d'un ABS transparent. Lors du remplissage de l'empreinte 53 du moule, la couche décorative 16′ se détache de la feuille support 12 et adhère à la face principale du volume qu'occupe le matériau plastique. Lors du démoulage et de l'extraction du corps de carte ainsi obtenu la feuille support 12 reste dans le moule.

La figure 5 montre le corps de carte ainsi obtenu. Le corps de carte 80, avec sa cavité 82 qui débouche dans sa face principale 84, est entièrement transparent. La face principale postérieure 86 est formé par la couche décorative 16′. Si l'on regarde le corps de carte 80 par sa face avant 84 on voit, à travers le matériau transparent, le graphisme formé par la sous-couche décorative 15′. Au contraire, si l'on regarde le corps de carte par sa face postérieure 86 on voit directement le graphisme défini par la sous-couche décorative 17′. Compte tenu de l'épaisseur réduite du corps de carte, 0,8 mm, l'effet optique dû à la couche de matériau transparent est négligeable.

La figure 6 montre une variante de moule utilisable pour réaliser une carte à mémoire électronique présentant des éléments graphiques sur ses deux faces principales. Le moule est constitué en trois parties. Une première partie 90, mobile, comporte la partie 92 de l'empreinte du moule qui définit la première face principale du corps de carte, y compris le noyau 93 servant à définir la cavité dans le corps de carte.

Une deuxième partie 94, mobile, comporte la partie 96 de l'empreinte du moule qui définit la deuxième face principale du corps de carte. Une troisième partie 98, fixe, qui est enserrée entre les parties 90 et 94 du moule lorsque celui-ci est fermé, comporte la partie 100 de l'empreinte qui définit le bord ou la tranche du corps de carte. La partie 98 du moule comporte, par exemple, deux buses d'injection 102 et 104.

La fabrication d'une carte à l'aide du moule de la figure 6 est réalisée de la manière suivante : le moule est ouvert, c'est-à-dire que les parties 90 et 94 sont écartées de la partie fixe 98. Un premier film 12a support d'éléments d'impression est placé entre les parties 90 et 98 du moule comme cela a déjà été décrit en liaison avec la figure 3. L'élément support 12a comporte une ouverture 12c pour le passage du noyau 93.

Un deuxième film 12b support d'éléments d'impression, est placé de la même manière entre les parties 98 et 94 du moule. Puis on ferme le moule à l'aide de moyens de verrouillage non représentés sur la figure 6. Ainsi les films support 12a et 12b sont solidaires du moule puisqu'ils sont pincés entre les trois parties 90, 94 et 98 du moule. On procède ensuite à l'injection du matériau plastique dans le moule par les buses 102 et 104, et on démoule la carte ainsi obtenue, les films support 12a et 12b restant dans le moule, seul les éléments graphiques formés par les couches décoratives restant fixés sur les faces principales du corps de carte.

Dans les différentes variantes du premier mode de réalisation décrites précédemment le graphisme sur le corps de carte est obtenu par transfert, lors du moulage, d'une couche décorative depuis la feuille support de l'élément support d'impression sur le matériau plastique formant le corps de carte.

Il est également possible selon un deuxième mode de mise en oeuvre de l'invention de réaliser le graphisme à l'aide d'un élément support d'impression qui forme une "étiquette". En d'autres termes c'est l'ensemble formé par la feuille support et la couche décorative qui adhère au matériau plastique lors de l'injection de ce matériau dans le moule.

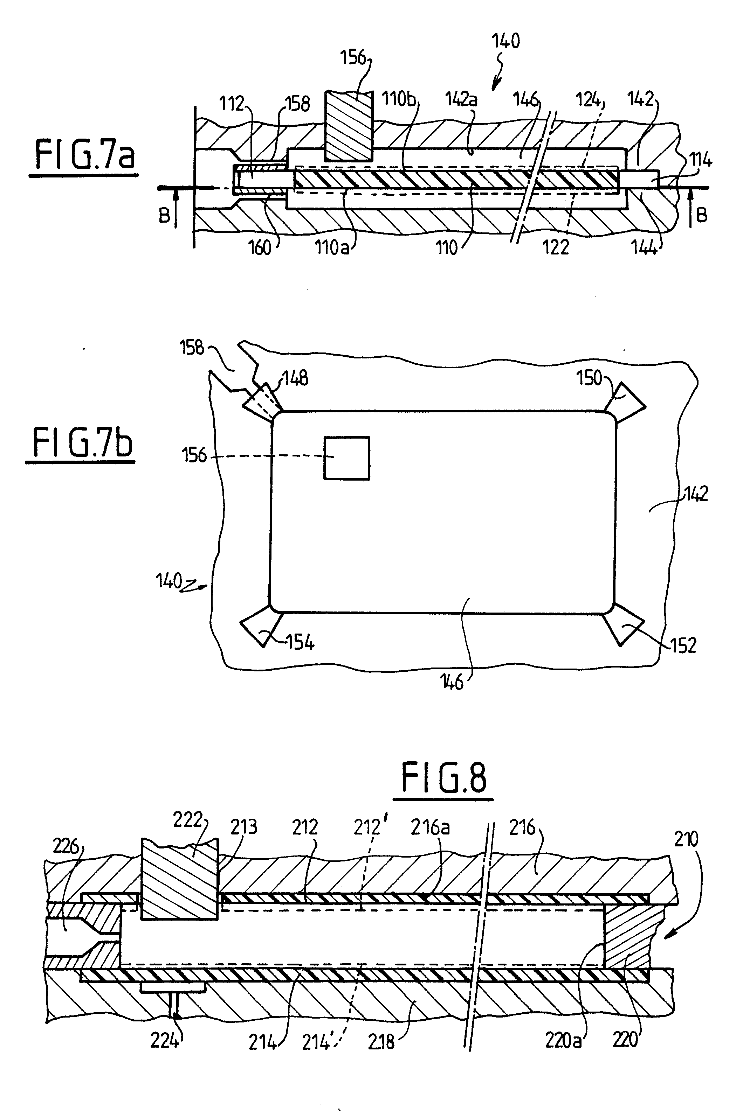

Les figures 7a et 7b illustrent ce deuxième mode de réalisation du graphisme sur la carte.

L'élément support est constitué par une portion (110) d'une feuille de matériau plastique qui a la forme générale des faces principales du corps de carte, c'est à dire une forme rectangulaire. l'élément support comporte en outre quatre prolongements partant chacun d'un sommet de l'élément support proprement dit. Seuls les prolongements 112 et 114 sont visibles sur la figure 7a. L'élément support 110 est par exemple découpé dans une feuille de polycarbonate dont l'épaisseur est de l'ordre de 0,1 mm. Sur les reste deux faces 110a et 110b de l'élément support ou sur une seule de celles-ci on réalise par tous moyen les graphismes souhaités, figurés en 122 et 124 sur la figure 7a. Bien entendu sur une même feuille de polycarbonate on réalise simultanément les impressions correspondant à un grand nombre d'éléments support, et les éléments support 10 sont individualisés ensuite par découpage afin d'obtenir la forme représentée sur les figures.

Les figures 7a et 7b montrent une forme de moule utilisable pour réaliser un corps de carte à mémoire électronique à partir de l'élément support 110. Le moule 140 comporte deux parties 142 et 144 qui définissent une empreinte ou cavité 146 ayant la forme extérieure du corps de la carte à réaliser. La partie 42 du moule comporte en outre des cavités 148 à 154 correspondant aux prolongements de l'élément support 110. La face principale 142a de la cavité 146 comprend un noyau 156 qui fait saillie dans la cavité 146 pour définir un évidement dans le corps de carte permettant de fixer le module électronique. Le moule 140 comprend également deux conduits d'injection 158 et 160 appartenant respectivement aux parties 142 et 144 du moule et débouchant dans un "coin" de la cavité interne 146 du moule.

La fabrication de la carte est réalisée de la manière suivante. l'élément support 110 est placé dans la partie 142 du moule 140. Plus précisément les prolongements de l'élément support sont disposés dans les cavités 148 à 154. Puis la partie 144 du moule est fixée sur la partie 142.

l'élément support 110 est ainsi positionné et rendu solidaire du moule par les prolongements tels que 112 et 114. L'élément 110 sépare la cavité 146 en deux demi-cavités. On procède alors, par les canaux d'injection 158 et 160, à l'injection du matériau plastique servant à réaliser le corps de carte dans la cavité 146 de part et d'autre de l'élément 110. Le matériau plastique d'injection est un matériau transparent apte à adhérer au matériau constituant l'élément support 110. On choisit de préférence également un polycarbonate. Lors de l'injection le matériau plastique remplit la partie de la cavité 146 non occupée par l'élément support 110, définissant ainsi le corps de carte. On démoule ensuite la pièce ainsi réalisée en séparant la partie 144 de la partie 142 du moule. On découpe ensuite les "coins" du corps de carte pour leur donner l'arrondi convenable et pour supprimer les prolongements tels que 112 et 114 ainsi que les "carottes" d'injection. Après l'opération de découpage on obtient un corps de carte en un matériau transparent dans lequel est noyé l'élément support. Du fait que le matériau plastique du corps est transparent les éléments graphiques, dessins ou indications alphanumériques, sont visibles comme dans une carte réalisée par un procédé déjà connu. De plus le graphisme est protégé par le matériau plastique transparent.

Au lieu du polycarbonate, on peut utiliser d'autres matériaux plastiques moulables transparents tels que les polysulphones transparents ou des polyesters transparents moulables. On pourrait également utiliser un polystyrène crystal ou des styrène-acrylonitryl.

Selon une première variante de ce deuxième mode de mise en oeuvre de l'invention l'élément support 110 présente des dimensions supérieures à celles des faces principales du corps de carte, et les prolongements sont supprimés. L'élément support est mis en place dans le moule. Lorsqu'on referme celui-ci la périphérie de l'élément support est pincée entre les parties 142 et 144 du moule. Après le démoulage, il faut découper la périphérie de l'élément support qui déborde du corps de carte.

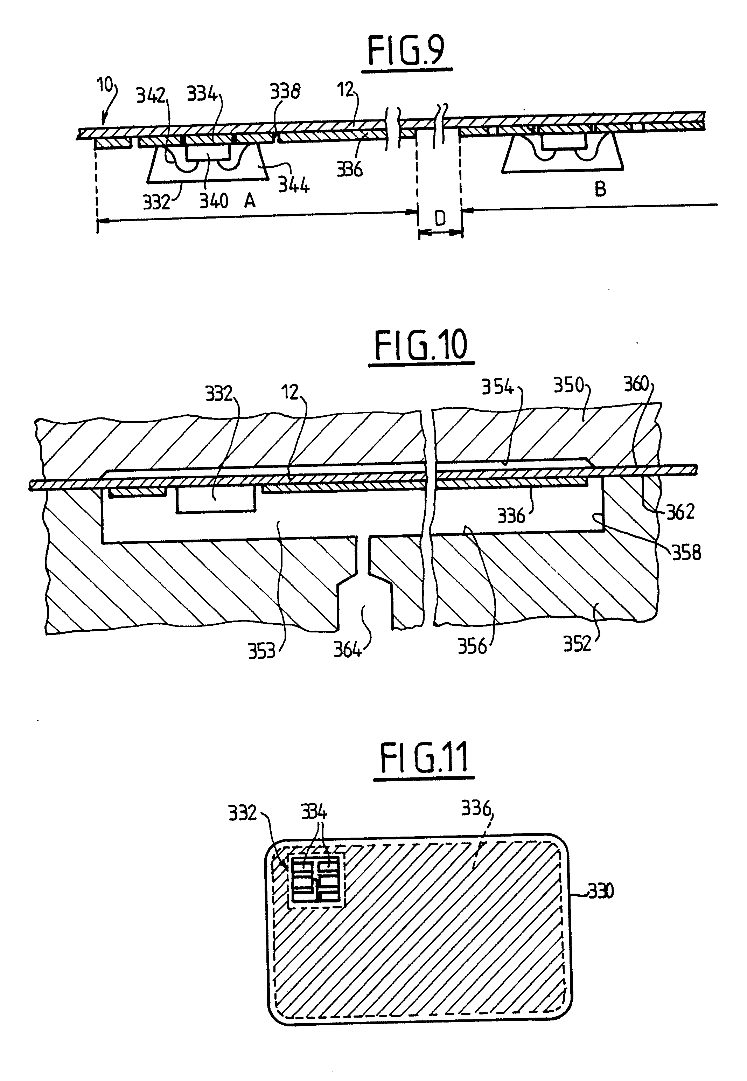

La figure 8 montre un autre mode de réalisation d'un moule 210 pour une deuxième variante du deuxième mode de mise en oeuvre du procédé selon l'invention. Selon cette variante les éléments graphiques avant 212 et arrière 214 munis de leurs graphismes 212′ et 214′ sont semblables à l'élément support 110 de la figure 7 mais ils ont des dimensions supérieures à celles des faces principales du corps de carte. Le moule 210 se compose de trois parties : une partie avant 216 qui définit la face principale 216a du corps de carte ; une partie arrière 218 qui définit la face principale arrière 218a du corps de carte ; et une partie intermédiaire 220 qui définit la paroi latérale 220a du corps de carte et l'épaisseur de la carte. Les parties 216 et 218 du moule comportent de préférence des systèmes à dépression tels que 224 pour mieux maintenir en place les éléments support. En outre, la partie 216 comporte un noyau 222 pour définir la cavité à réaliser dans le corps de carte.

Pour fabriquer la carte on opère de la manière suivante. Le moule étant ouvert, on met en place l'élément support 212, contre la face 216a du moule. L'élément support 212 comporte une ouverture 213 pour le passage du noyau 222. Puis on met en place l'entretoise 220, la périphérie de l'élément support 212 étant pincée entre les parties de moule 212 et 220. Puis on met en place l'élément support 214 et on rend actifs les systèmes à dépression 224. Enfin on met en place la partie 218 du moule, la périphérie de l'élément support 214 étant pincée entre l'entretoise et la partie 118 du moule. On procède alors à l'injection du matériau plastique dans le moule par le canal d'injection 226.

Dans la description précédente en liaison avec les figures 7 et 8 on a considéré que les éléments support munis de leur graphisme étaient découpés avant leur mise en place dans le moule. Cependant il va de soi que, dans les cas où l'élément support est maintenu en place dans le moule par pincement de sa périphérie entre deux parties du moule, les éléments support peuvent être laissés en bande. La bande est déplacée d'un pas avant chaque opération de moulage d'une carte pour qu'à chaque opération de moulage un élément support (ou deux éléments support dans le cas de la figure 8) soit présenté en regard de l'empreinte du moule, celui-ci étant bien sûr ouvert.

Par les différents modes de mise en oeuvre du procédé décrits précédemment on obtient un corps de carte portant un graphisme sur une ou sur les deux faces principales et muni d'une cavité pour recevoir le module électronique. Le module électronique est ensuite fixé dans la cavité par différentes techniques notamment celles qui sont décrites dans les demandes de brevet européens 197.847 et 254.640.

Selon un troisième mode de mise en oeuvre de l'invention il est possible d'obtenir directement la carte avec son module électronique et ses graphismes réalisés sur une ou les deux faces du corps de carte. Ce troisième mode de réalisation de cartes consiste à faire jouer à la feuille support de l'élément support un double rôle d'une part elle supporte les couches décoratives pour réaliser les graphismes : d'autre part elle sert de support temporaire et de moyen de positionnement du module électronique dans le moule d'injection. Ainsi le module électronique se trouve enrobé, à l'exception de sa face d'accès, dans le matériau plastique formant le corps de carte.

Cette technique peut s'appliquer à tous les modes de réalisation décrits précédemment. On se contentera donc de décrire deux exemples de mise en oeuvre du troisième mode de réalisation de l'invention.

En se référant maintenant aux figures 9 à 11 on va décrire un premier mode de réalisation de cartes à mémoire électronique selon l'invention.

On part d'un élément support 10 qui comporte une pluralité de motifs identiques, chaque motif correspondant à l'ensemble du graphisme qui doit être réalisé sur une des faces du corps de la carte. Sur la figure 10 on a représenté les motifs A et B. Chaque motif est séparé des motifs voisins par un espace vierge dont l'utilité sera explicitée ultérieurement.

La figure 11 montre un corps de carte 330 réalisé selon l'invention. Dans la face principale visible du corps de carte on a représenté le module électronique 332 dont seules les plages externes de contact électrique 334 sont visibles. On a également représenté en 336 les zones du corps de carte qui comportent un graphisme. La zone 336 laisse dégagée la portion de la face du corps de carte 330 occupée par les plages externes 334 de contact électrique.

Si l'on revient à la figure 9, on voit que, pour chaque motif, la zone où des graphismes 336 sont réalisés laisse à nu la partie 338 du support plastique 12 où doit se trouver le module électronique 332, lorsque la carte est terminée.

Le module électronique 332 comprend un lead frame ou un élément de circuit imprimé sur lequel sont réalisées les plages externes 334, une pastille semi conductrice 340 fixée sur le circuit imprimé ou le lead frame, des fils conducteurs 342 qui relient les bornes de la pastille 340 aux plages de contact 334 et un matériau d'enrobage 344 qui entoure la pastille 340 et les fils 342. Un module 332 est collé sur le support 12 à chaque emplacement 338, de telle manière que chaque motif comporte un module.

Comme le montre la figure 9, la face externe des plages externes de contact est directement collée sur le support 12.

On obtient ainsi une bande formée par le support 12 qui comporte sur une de ses faces une pluralité de motifs (A, B..) chaque motif comportant de plus un module électronique 332.

Dans l'étape suivante on réalise le corps de la carte par moulage par injection d'un matériau plastique qui est de préférence de l'ABS. La figure 10 montre le moule utilisé. Il comprend une partie fixe 350 et une partie mobile 352. Ces deux parties définissent une empreinte 353 qui donne la forme externe du corps de carte. La partie fixe 350 définit par sa paroi interne 354 une des faces principales du corps de carte. La partie mobile 352 définit par sa paroi interne 356 la deuxième face principale du corps de carte et par sa paroi interne 358 la tranche du corps de carte. Les parties fixe 350 et mobile 352 comportent chacune une portée 360 et 362, ces deux portées étant normalement en contact mutuel lorsque le moule est fermé.

Le moule étant ouvert, la bande formée par le support 12 est placée entre la partie fixe 350 et la partie mobile 352 du moule. La bande est positionnée par rapport à l'empreinte 353 de telle manière que le graphisme 16 portée par le support 12, et, par voie de conséquence, le module électronique 332 soient parfaitement positionnés par rapport à la paroi latérale 358 de l'empreinte, c'est-à-dire par rapport à la tranche du corps de carte qui va être réalisé. Puis le moule est fermé. Le support 12 est pincé entre les portées 358 et 360 des deux parties du moule dans la zone D du support 12 qui entoure un motif. Puis on procède à l'injection du matériau plastique dans l'empreinte 353 par la buse d'injection 364, l'ABS est injecté de préférence à une température comprise entre 220°C et 280°C.. De préférence la buse 364 est disposée au centre de la paroi 56 de la partie mobile 352. Le matériau plastique remplit l'empreinte 353 en plaquant le support 12 contre la paroi interne 354 du moule. Le matériau plastique entoure le module électronique 332, à l'exception de sa face collée sur le support 12 et il est au contact du graphisme 336. Sous l'effet de la pression et de la température, les éléments décoratifs 336 se fixent sur la face correspondante du volume de matériau plastique en tendant à se séparer du support 12. Ce résultat est obtenu par l'activation de la couche d'adhésif 20 et de la couche de décollement 14.

Si le module électronique 332 a une épaisseur suffisamment réduite par rapport à l'épaisseur de la carte, il est possible de prévoir que la buse d'injection débouche 364 dans la face 356 du moule, en regard du module électronique. On peut également prévoir plusieurs buses d'injection. Egalement il est possible de disposer des buses d'injection dans la face latérale 358 de l'empreinte du moule. De préférence alors les buses sont disposées à certains "coins" de l'empreinte du moule.

Après avoir ouvert le moule on démoule le corps de carte dans lequel est inserré le module électronique 332 et qui comporte le graphisme 336 désiré sur sa face principale.

On comprend que le support 12 joue un double rôle, il permet la réalisation du graphisme, et il assure le positionnement précis du module électronique par rapport à l'empreinte du moule et donc par rapport au corps de carte. De plus les plages externes du module étant collées sur le support 12, elles sont protégées contre une éventuelle remontée du matériau d'injection qui pourrait tendre à les recouvrir.

Le support 12 qui ne porte plus ni module électronique ni les graphismes reste dans le moule après l'enlèvement de la carte.

En se référant maintenant aux figures 12 et 13 on va décrire un deuxième exemple du troisième mode de mise en oeuvre de l'invention. Selon ce deuxième mode de réalisation, deux éléments support correspondant à chacune des faces principales du corps de carte sont mis en place avant l'injection du matériau plastique.

La figure 12 montre l'élément support avant 470 et l'élément support arrière 472. L'élément support avant 470 constitue en même temps le support isolant du module électronique. L'élément avant 470 est constitué par une feuille rectangulaire 474, par exemple en ABS qui a la forme des faces principales de la carte à réaliser. Dans la zone convenable, la feuille 474 comporte sur sa face externe 474a des métallisations 476 qui forment les plages externes de contact électrique de la carte. Une pastille semi-conductrice 478 est fixée sur la face interne 474b du support 474 et des connexions 480 assurent la liaison électrique entre les bornes de la pastille semi-conductrice 478 et les plages externes 476. La pastille 478 et les connexions 480 sont de préférence enrobées dans un matériau isolant 482.

Avant la fixation de la pastille 478, des impressions graphiques 483 sont réalisées sur là face externe 474a de la feuille 474 dans sa partie non occupée par les métallisations 476.

L'élément support arrière 472 est également constitué par une portion de feuille 484 un matériau plastique qui a les dimensions de la face principale arrière du corps de carte. Sur la face externe 484a de la feuille 484 sont réalisées les impressions requises 486.

La figure 13 montre en coupe verticale un moule 490 utilisable pour la réalisation d'une carte selon le deuxième mode de mise en oeuvre de l'invention. Le moule 490 comprend une première partie 492 qui définit une cavité 494 ayant la forme externe du corps de la carte à réaliser. La partie 492 du moule comprend une pluralité de systèmes à dépression 500 débouchant dans la face principale 492a de la cavité 494. Elle comprend également un canal d'injection 496 débouchant dans un "coin" de la cavité 494. La deuxième partie 498 du moule 490 définit la deuxième face principale 498a du corps de carte. Une pluralité de systèmes à dépression 500 débouchent dans la face 498a de la partie 498 du moule.

La fabrication d'une carte à mémoire selon ce deuxième mode de mise en oeuvre est obtenue de la manière suivante : On met en place contre la face 492a de la partie 492 du moule l'élément support avant 470 qui comporte également le module électronique. On rend actif les systèmes à dépression ce qui maintient ferment l'élément 470 contre la face 492a. De la même manière on met en place l'élément support arrière 472 contre la face 498a de la partie 498 du moule 490 et l'on rend actifs les systèmes à dépression 500 pour maintenir l'élément support 472 contre la face 498a. On referme alors le moule en fixant la partie 498 sur la partie 492. Par le canal d'injection 496 on fait pénétrer un matériau plastique convenable qui remplit la cavité 494 et adhère aux faces internes des éléments support 470 et 472. De préférence le matériau d'injection est le même que celui qui constitue les éléments support 470 et 472.

On ouvre ensuite le moule 490 et on en extrait la pièce ainsi obtenue. On réalise ainsi une carte à mémoire qui comporte sur ses deux faces principales les éléments graphiques, éléments graphiques qui ont été réalisés sur les éléments support avant la réalisation proprement dite de la carte.

**Revendications**

1. Procédé de réalisation d'une carte comportant un corps de carte et au moins un élément graphique caractérisé en ce qu'il comprend les étapes suivantes :
    a) On fournit un moule dont l'empreinte définit la forme extérieure du corps de carte;
    b) On dispose dans le moule au moins un élément support comportant un élément graphique, et on maintenir en place ledit élément support pour qu'il reste sensiblement parallèle aux face de l'empreinte du moule définissant les faces principales du corps de carte;
    c) On injecte dans ledit moule un matériau plastique de telle manière que le matériau plastique occupe la totalité de l'espace limité par l'empreinte dudit moule non occupé par ledit élément support ; et
    d) On démoule la pièce ainsi réalisée.

2. Procédé selon la revendication 1, caractérisé en ce que, durant l'étape b), on dispose de plus dans ledit moule un module électronique présentant une face d'accès et on maintient ledit module électronique pour que sa face d'accès soit plaquée contre une des faces principales de l'empreinte, et en ce que, durant l'étape c), le matériau plastique remplit la totalité de l'espace limité par l'empreinte dudit moule non occupé par ledit élément support et ledit module électronique.

3. Procédé selon une quelconque des revendications 1 et 2, caractérisé en ce que l'élément support est réalisé en un matériau non transparent muni sur au moins une de ses faces d'un élément graphique et dans lequel ledit matériau plastique est transparent.

4. Procédé selon la revendication 2, caractérisé en ce que ledit module électronique est fixé sur ledit élément support avant leur mise en place dans ledit moule.

5. Procédé selon la revendication 1, caractérisé en ce que ledit élément support a des dimensions sensiblement égales à celles des faces principales du corps de carte et il présente en outre des extensions pour maintenir en place ledit élément support dans l'empreinte dudit moule, et en ce que lesdites extensions sont découpées après l'opération de démoulage.

6. Procédé selon la revendication 1 caractérisé en ce que le matériau plastique d'injection est un polycarbonate transparent.

7. Procédé selon la revendication 6, caractérisé en ce que l'élément support est également réalisé en polycarbonate.

8. Procédé selon la revendication 1 caractérisé en ce qu'on dispose dans ledit moule deux éléments support et en ce qu'on maintien chaque élément support contre une des faces principales de l'empreinte dudit moule, chaque élément support comportant un élément graphique sur une de ses faces.

9. Procédé selon la revendication 8 caractérisé en ce que les éléments de graphisme sont réalisés sur la face des éléments support non en contact avec les parois du moule lesdits éléments support étant réalisés en un matériau transparent.

10. Procédé de réalisation d'une carte à mémoire comprenant un corps de carte présentant des première et deuxième faces principales parallèles entre elles caractérisé en ce qu'il comprend les étapes suivantes :
On fournit un moule dont l'empreinte définit la forme extérieure qu'on veut donner au corps de la carte;
On fixe, par sa périphérie, dans ledit moule un élément support disposé parallèlement auxdites faces principales, ledit support présentant sur une de ses faces des éléments d'impression pour définir un graphisme à réaliser sur une face principale de la carte;
On injecte dans ledit moule un matériau plastique pour que celui-ci remplisse ladite empreinte du moule et que lesdits éléments d'impression adhèrent à la face du matériau injecté en contact avec ledit élément support;
On démoule ladite pièce ainsi obtenue et on sépare l'élément support de ladite pièce, par quoi les dits éléments d'impression restent sur ladite face dudit corps.

11. Procédé selon la revendication 10 caractérisé en ce que les éléments d'impression comprennent des éléments de graphisme fixés sur ledit support par une couche de détachement et en ce que la face des éléments de graphisme non tournée vers ledit support est recouverte d'un matériau adhésif activable à chaud.

12. Procédé selon la revendication 11 caractérisé en ce que le matériau plastique est de l'ABS.

13. Procédé selon l'une quelconque des revendications 11 et 12 caractérisé en ce que les éléments d'impression comprennent des éléments de graphismes formés de deux couches décoratives entre lesquelles est interposée une couche opaque séparatrice et en ce que le matériau plastique injecté est transparent.

14. Procédé selon l'une quelconque des revendications 10 à 13 caractérisé en ce que ledit moule comporte des moyens pour réaliser une cavité dans la première face principale dudit corps de carte et en ce que ledit élément support est fixé dans ledit moule à proximité de la face de l'empreinte dudit moule définissant ladite deuxième face du corps de carte.

## FIG.1

## FIG.2a

## FIG.2b

FIG.3

FIG.4

FIG.5

## FIG.6

## FIG.12

## FIG.13

FIG.7a

FIG.7b

FIG.8

## FIG.9

## FIG.10

## FIG.11

<table>
<tr><td colspan="4"><strong>RAPPORT DE RECHERCHE EUROPEENNE</strong></td></tr>
</table>

Office européen des brevets

**RAPPORT DE RECHERCHE EUROPEENNE**

Numero de la demande

EP    89 40 1172

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| A | GB-A-2081974 (GAO GESELLSCHAFT FUR AUTOMATION UND ORGANISATION) <br> * page 2, ligne 54 - page 3, ligne 26; figures 1-7 * | 1, 2, 4, 11 | G06K19/06 |
| A | GB-A-2096541 (GAO GESELLSCHAFT FUR AUTOMATION UND ORGANISATION) <br> * page 3, ligne 109 - page 4, ligne 79; figures 18-20 * | 1, 2, 4-5, 11 | |
| A | PATENT ABSTRACTS OF JAPAN <br> vol. 9, no. 320 (P-413)(2043) 14 décembre 1985, <br> & JP-A-60 146383 (DAINIPPON INSATSU K.K.) 02 août 1985, <br> * le document en entier * | 1, 2, 4, 11 | |
| A | PATENT ABSTRACTS OF JAPAN <br> vol. 9, no. 230 (E-343)(1953) 17 septembre 1985, <br> & JP-A-60 86850 (DAINIPPON INSATSU K.K.) 16 mai 1985, <br> * le document en entier * | 1, 2, 4, 11 | DOMAINES TECHNIQUES RECHERCHES (Int. Cl.4 ) |
| A | LU-A-81049 (RUWA-BELL) <br> * revendications 1, 4; figures 1, 2 * | 1, 3 | G06K <br> B42D |
| D,P, A | EP-A-267826 (SCHLUMBERGER INDUSTRIES) <br> * revendications 1-2; figure 3 * | 1, 10 | |
| P,A <br><br> D | EP-A-277854 (SCHLUMBERGER INDUSTRIES) <br> * revendications 1-3; figures 2-5 * <br> & FR-A-2609821 | 1-2, 10 | |

Le présent rapport a été établi pour toutes les revendications

| Lieu de la recherche | Date d'achèvement de la recherche | Examinateur |
|---|---|---|
| LA HAYE | 01 AOUT 1989 | GYSEN L.A.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)